# EUROPÄISCHE PATENTANMELDUNG

(11) **EP 0 819 563 A2**
(43) Veröffentlichungstag der Anmeldung: **21.01.1998**
(21) Anmeldenummer: 97810404.0
(22) Anmeldetag: 25.06.1997
(51) Int. Cl.: B60L 9/00

(54) **Stromrichterschaltungsanordnung**

(30) Priorität: 20.07.1996 DE 19629333
(71) Anmelder: ABB Daimler-Benz Transportation (Technology) GmbH, 13627 Berlin (DE)
(72) Erfinder: Manser, Roland, 8165 Oberweningen (CH)
(74) Vertreter: Weibel, Beat

(57) **Zusammenfassung**

Es wird eine Stromrichterschaltungsanordnung angegeben, bei der zwei Teilstromrichter vorgesehen sind, die je eine Teilwicklung einer Motors speisen. Die Beschaltungen der Leistungshalbleiterschalter der Teilstromrichter sind spiegelsymmetrisch zueinander angeordnet. Dadurch kann der Anteil an harmonischen Störkomponenten, insbesondere der dritten Harmonischen, wirksam verkleinert werden.

## Beschreibung

### Technisches Gebiet

Die Erfindung bezieht sich auf das Gebiet der Leistungselektronik. Sie geht aus von einer Stromrichterschaltungsanordnung nach dem Oberbegriff des ersten Anspruchs.

### Stand der Technik

Eine solche Stromrichterschaltungsanordnung wird beispielsweise in der Europäischen Patentanmeldung Nr. 0 543 203 A1 beschrieben. Sie betrifft eine sogenannten Doppelsternschaltung, bei der ein erster Teilstromrichter und ein zweiter Teilstromrichter in Serie geschaltet sind. Die Teilstromrichter speisen dabei je eine in Stern geschaltete Wicklung eines Drehstrommotors ("Doppelsternschaltung"). Diese Schaltung kommt insbesondere in Bahnantrieben gespeist von einem 3 kV Gleichspannungsnetz zum Einsatz. Die Serieschaltung der Teilstromrichter löst dabei das Problem, dass bei diesen Netzen, deren Spannungsbereich ja zwischen 2 kV und 4.5 kV variiert, derzeit erhältliche GTOs (bis gegen 4.5 kV Sperrspannung) nicht eingesetzt werden können. Durch die Aufteilung der Spannung auf zweimal 1.5 kV können diese Spannungen sicher beherrscht werden. Eine andere Lösung hierfür stellt der sogenannte Dreipunktwechselrichter dar (siehe z.B. DE 37 43 437 C1).

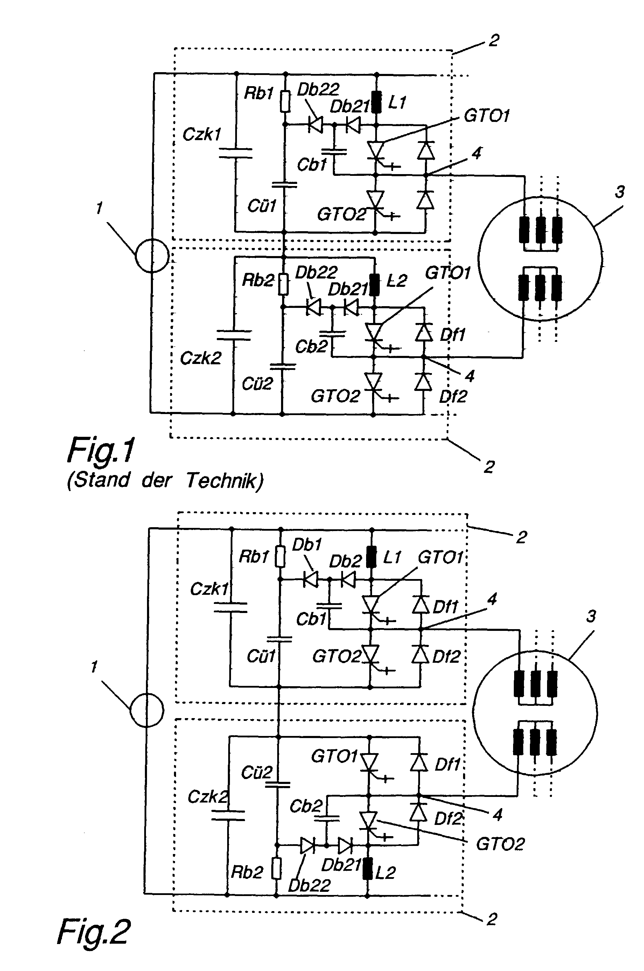

Die Leistungshalbleiterschalter des ersten und zweiten Teilstromrichters müssen durch ein Beschaltungsnetzwerk vor zu hohen Spannungen und Strömen bzw. zu steilen Spannungs- oder Stromflanken geschützt werden. Im Rahmen dieser Doppelsternschaltung wird die sogenannte "Undeland-" oder "Marquardt"-Beschaltung bevorzugt eingesetzt. Für die beiden Teilstromrichter ergibt sich somit eine Schaltungsanordnung, wie sie in Figur 1 dargestellt ist. Im Rahmen von weiterführenden Untersuchung an dieser Schaltung hat sich gezeigt, dass Störkomponenten in Form von Oberschwingungen, insbesondere einer dritten Harmonischen, auftreten. Gerade aber in Gleichspannungsbahnnetzen werden höchste Anforderungen an Netzrückwirkungen gestellt, die im Hinblick auf den Einfluss dieser dritten Harmonischen kaum eingehalten werden können.

### Darstellung der Erfindung

Aufgabe der vorliegenden Erfindung ist es, eine Stromrichterschaltungsanordnung nach dem Stand der Technik so weiterzuentwickeln, dass sie bezüglich dem Anteil an Harmonischen verbessert wird. Insbesondere soll der Einfluss der dritten Harmonischen verringert werden.

Diese Aufgabe wird bei einer Stromrichterschaltungsanordnung der eingangs genannten Art durch die Merkmale des ersten Anspruchs gelöst.

Kern der Erfindung ist es also, dass die Beschaltungsnetzwerke der Teilstromrichter spiegelsymmetrisch angeordnet sind. Die Spiegelsymmetrie bezieht sich dabei schaltungstechnisch auf eine virtuelle bzw. potentialmässige Ebene, die zwischen den Polen der Gleichspannungsquelle aufgespannt ist..

Messergebnisse ergaben, dass die erfindungsgemässe Schaltungsanordnung gegenüber dem Stand der Technik mit nicht spiegelsymmetrischer Schaltungsanordnung bezüglich Anteil an Harmonischen weit überlegen ist. Insbesondere die vergleichsweise tiefe dritte Harmonische konnte vollständig eliminiert werden. Als Grund hierfür wird die Tatsache angesehen, dass bei einer asymmetrischen Anordnung nach den Stand der Technik, je nachdem ob der obere oder untere GTO eines Teilstromrichters eingeschaltet ist, ein statischer Energieunterschied zwischen den beiden Schaltzuständen besteht. Wenn der obere GTO leitet, ist der Beschaltungskondensator parallel zu diesem GTO entladen, und der Strom fliesst in der Drossel. Wenn der untere GTO eingeschaltet ist, ist der Strom durch die Drossel gleich Null, und der Beschaltungskondensator ist aufgeladen. Diese Energiedifferenz muss durch den Zwischenkreis periodisch gedeckt werden. Dies verursacht für einen Teilstromrichter alleine eine Störstromkomponente mit der gleichen Frequenz wie die Schaltfrequenz dieses Teilstromrichters. Die erwähnte dritte Harmonische der Taktfrequenz entsteht nun dadurch, dass im Normalfall drei Phasenbausteine, die um 120° phasenverschoben angesteuert werden, parallelgeschaltet sind. Für die gesamte Stromrichterschaltungsanordnung ergibt sich somit eine Störkomponente mit dreifacher Frequenz: eine dritte Harmonische.

Die Erfindung wird mit Vorteil für Schaltungsanordnungen verwendet, die die sogenannte "Undeland"- oder "Marquardt-Beschaltung" verwenden. Dies Beschaltungen sind wie erwähnt asymmetrisch.

Die Erfindung ist im übrigen nicht auf GTOs beschränkt, sondern findet auch bei einem Stromrichter z.B. mit Leistungstransistoren oder auch mit IGBTs vorteilhafte Anwendung. Weitere Ausführungsbeispiele ergeben sich aus den entsprechenden abhängigen Ansprüchen.

Der Vorteil des erfindungsgemässen Aufbaus besteht darin, dass mit der symmetrischen Beschaltung der Anteil an Harmonischen wirksam vermindert werden kann.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Eine Stromrichterschaltungsanordnung nach dem Stand der Technik;
- **Fig. 2**: Eine Stromrichterschaltungsanordnung nach der Erfindung.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

**Figur 2** zeigt ein Ausführungsbeispiel der vorliegenden Erfindung. Es handelt sich dabei um einen Phasenbaustein eines vorzugsweise dreiphasigen Umrichters. Die übrigen Phasenbausteine sind der Übersicht halber nicht dargestellt und nur durch die gestrichelten Linien angedeutet. Die Phasenbausteine sind an eine Gleichspannungsquelle 1, insbesondere ein Gleichspannungstraktionsnetz von z.B. 3 kV, angeschlossen. Sie umfassen zwei Teilstromrichter 2, die in Serie geschaltet sind. Jeder Teilstromrichter speist eine Teilwicklung eines Antriebsmotors 3. Die Teilwicklungen des Motors 3 sind dabei je in Stern geschaltet, so dass man auch von einer Doppelsternschaltung spricht.

Jeder Teilstromrichter 2 umfasst eine Serienschaltung zweier Leistungshalbleiterschalter, insbesondere zweier GTOs, GTO1 und GTO2. Anstelle von GTOs können auch andere Leistungshalbleiterschalter zu Einsatz kommen: z.B. IGBTs oder Leistungstransistoren. Parallel zu den GTOs ist je eine Freilaufdiode Df1, Df2 geschaltet. Die mittleren Knoten der Serieschaltung der Leistungshalbleiterschalter bilden einen Lastanschluss 4, an welche eine Last, z.B. die erwähnten Teilwicklungen eines Antriebsmotors, angeschlossen werden kann. Parallel zur Gleichspannungsquelle 1 ist ein Zwischenkreiskondensator angeordnet, der im vorliegenden Falle mit zwei Teilstromrichtern in einen unteren Czk2 und einen oberen Czk1 aufgeteilt ist. Mittels Schalten der Leistungshalbleiterschalter wird nun entweder der positive oder der negative Pol der Gleichspannungsquelle 1 an den Lastanschluss 4 geschaltet. Im vorliegenden Falle mit zwei Teilstromrichtern 2 wird die Gleichspannung durch die beiden Zwischenkreiskondensatoren Czk1, Czk2 halbiert. Auf diese Weise kann die spannungsmässige Belastung der Leistungshalbleiterschalter vermindert werden.

Die Leistungshalbleiterschalter und die Freilaufdioden müssen im Betrieb vor zu hohen Strom- bzw. Spannungsflanken geschützt werden. Dazu ist ein Beschaltungsnetzwerk vorgesehen. Dieses umfasst im Rahmen der Erfindung die sogenannte Undeland- oder Marquardt-Beschaltung. Dieses Beschaltungsnetzwerk umfasst pro Teilstromrichter folgende Elemente: eine Stromanstiegsbegrenzungsdrossel L1 bzw. L2, einen Beschaltungskondensator Cb1 bzw. Cb2, einen Überlaufkondensator Cü1 bzw. Cü2, einen Beschaltungswiderstand Rb1 bzw. Rb2 und zwei Dioden: eine erste Beschaltungsdiode Db11 bzw. Db21 und eine zweite Beschaltungsdiode Db21 bzw. Db22.

Diese Art der Beschaltung ist an sich bekannt, so dass auf eine Erläuterung der Funktionsweise an dieser Stelle verzichtet werden kann. Die Anwendung dieser Schaltung auf eine Doppelsternschaltung führt zur Schaltungsanordnung, wie sie in Figur 1 dargestellt ist und im eingangs genannten Stand der Technik ausgeführt wurde. Diese Schaltungsanordnung weist aber wie vorstehend erläutert Nachteile bezüglich des Anteils an harmonischen Schwingungen auf. Diese unerwünschten Anteile können nun durch die Erfindung vermieden werden, indem die Beschaltung spiegelsymmetrisch aufgebaut wird. Die entsprechende Anordnung zeigt Figur 2.

Nach der Erfindung ist also die Stromanstiegsbegrenzungsdrossel L1 des oberen Teilstromrichters 2 zwischen dem Pluspol der Gleichspannungsquelle 1 und der Serieschaltung der Leistungshalbleiterschalter GTO1, GTO 2 angeordnet, während die Drossel L2 des unteren Teilstromrichters 2 zwischen dem Minuspol und den Leistungshalbleiterschaltern GTO1, GTO 2 angeordnet ist. Auch die Reihenfolge der Serieschaltung des Beschaltungswiderstand Rb2 und des Überlaufkondensators Cü2 ist beim unteren Teilstromrichter umgekehrt, so dass der Widerstand Rb2 mit dem Minuspol in Verbindung steht und nicht der Kondensator Cü2. Die Spiegelsymmetrie gilt auch für den Beschaltungskondensator Cb2 und die damit verbundenen Beschaltungsdioden Db21 und Db22: Der Beschaltungskondensator Cb2 liegt nicht mehr parallel zu oberen Schalter GTO1 sondern zum unteren Schalter GTO2. Der Kondensator Cb2 ist dabei jeweils über Beschaltungsdioden Db22 bzw. Db21 einerseits mit dem mittleren Knotenpunkt der Serieschaltung Rb2-Cü2 und andererseits mit dem Verbindungspunkt des unteren Schalters GTO2 und der Stromanstiegsbegrenzungsdrossel L2 verbunden. Die Polarität der Dioden Db21 und Db22 ist aufgrund der nach der Erfindung spiegelsymmetrischen Anordnung der Beschaltungsnetzwerke der beiden Teilstromrichter beim unteren umgekehrt als beim oberen.

Die eben beschriebene, erfindungsgemässe Stromrichterschaltungsanordnung, bei der die Beschaltungsnetzwerke des oberen und unteren Teilstromrichters 2 spiegelsymmetrisch angeordnet sind, weist gegenüber den Stand der Technik den Vorteil auf, dass die vorstehend erklärte Störkomponente nicht mehr auftritt. Durch den spiegelsymmetrischen Aufbau kompensieren sich die Einflüsse in den beiden Teilstromkreisen. Im gemeinsamen Zwischenkreis treten diese Störkomponenten gar nicht mehr auf.

Der Stand der Technik konnte somit im Hinblick auf den Anteil an Harmonischen weiter verbessert werden.

### Bezugszeichenliste

- 1: Gleichspannungsquelle
- 2: Teilstromrichter
- 3: Motor
- 4: Lastanschluss
- Czk1, Czk2: Zwischenkreiskondensator
- Cü1, Cü2: Überlaufkondensator
- Rb1, Rb2: Beschaltungswiderstand
- Cb1, Cb2: Beschaltungskondensator
- Db11, Db12, und Db21, Db22: Beschaltungsdioden
- L1, L2: Stromanstiegsbegrenzungsdrosseln
- GTO1, GTO2: Leistungshalbleiterschalter
- Df1, Df2: Freilaufdioden

## Patentansprüche

1. Stromrichterschaltungsanordnung umfassend mindestens einen Phasenbaustein, der an eine Gleichspannungsquelle (1) anschliessbar ist und einen ersten und einen zweiten Teilstromrichter (2), die in Serie geschaltet werden können, umfasst, welche Teilstromrichter (2) je eine in Stern geschaltete Wicklung eines Motors (3) speisen und eine Serieschaltung von Leistungshalbleiterschaltern umfassen, wobei die Leistungshalbleiterschalter mittels eines Beschaltungsnetzwerks geschützt werden, dadurch gekennzeichnet, dass das Beschaltungsnetzwerk des ersten Teilstromrichters spiegelsymmetrisch zu demjenigen des zweiten Teilstromrichters ausgebildet ist.

2. Stromrichterschaltungsanordnung nach Anspruch 1, dadurch gekennzeichnet, dass
- die Teilstromrichter (2) je eine Serieschaltung einer geraden Anzahl von Leistungshalbleiterschaltern (GTO1, GTO2) mit antiparallel geschalteten Freilaufdioden (Df1, Df2) umfassen;
- die Beschaltungsnetzwerke der Teilstromrichter je einen Beschaltungskondensator (Cb1 bzw. Cb2), eine erste und eine zweite Beschaltungsdiode (Db11, Db12 bzw. Db21, Db22), einen Überlaufkondensator (Cü1 bzw. Cü2), einen Beschaltungswiderstand (Rb1 bzw. Rb2) und eine Stromanstiegsbegrenzungsdrossel (L1 bzw. L2) umfassen, wobei der Beschaltungskondensator (Cb1 bzw. Cb2) über die erste Beschaltungsdiode (Db11 bzw. Db21) parallel zu demjenigen Leistungshalbleiterschalter (GTO1 bzw. GTO2) angeordnet ist, der näher beim Plus- bzw. Minuspol der Gleichspannungsquelle (1) liegt, und wobei die Stromanstiegsbegrenzungsdrossel (L1 bzw. L2) zwischen demjenigen Leistungshalbleiterschalter (GTO 1 bzw. GTO2), der näher beim Plus- bzw. Minuspol liegt, und dem Plus- bzw. Minuspol angeordnet ist, und wobei der Überlaufkondensator (Cü1 bzw. Cü2) mit dem Beschaltungswiderstand (Rb1 bzw. Rb2) in Serie geschaltet ist, parallel zur Serieschaltung der Leistungshalbleiterschaltern (GTO1, GTO2) und der Stromanstiegsbegrenzungsdrossel (L1 bzw. L2) liegt und über die zweite Beschaltungsdrossel (Db12 bzw. Db22) mit dem Beschaltungskondensator (Cb1 bzw. Cb2) verbunden ist, wobei der Beschaltungswiderstand (Rb1 bzw. Rb2) mit dem Plus- bzw. Minuspol der Gleichspannungsquelle verbunden ist.

3. Stromrichterschaltungsanordnung nach Anspruch 1 oder 2, dadurch gekennzeichnet, dass die Leistungshalbleiterschalter GTOs, Leistungstransistoren oder IGBTs sind.
